# EUROPEAN PATENT APPLICATION

(11) **EP 4 614 553 A1**
(43) Date of publication of application: **10.09.2025**
(21) Application number: 23886357.5
(22) Date of filing: 03.11.2023
(51) Int. Cl.: H01L 21/67

(54) **HIGH-PRESSURE SUBSTRATE PROCESSING APPARATUS**

(30) Priority: 04.11.2022 KR 20220146556
(71) Applicant: HPSP Co., Ltd., Hwaseong-si, Gyeonggi-do 18449 (KR)
(72) Inventor: LIM, Kunyoung, Suwon-si, Gyeonggi-do 16642 (KR)
(74) Representative: von Bülow & Tamada
(86) International application number: PCT/KR2023/017493
(87) International publication number: WO 2024/096663

(57) **Abstract**

The present invention provides a high-pressure substrate processing apparatus comprising: an inner chamber accommodating a substrate to be processed; an outer chamber provided with an outer housing accommodating the inner chamber and an outer door which is formed to be movable between a closed state in which the outer housing is closed and an open state in which the outer housing is opened; and a fastening module which is formed to fasten the outer housing with the outer door in the closed state, in order to maintain a processing gas for processing the substrate at a first pressure that is greater than the atmospheric pressure in the inner chamber and maintain a protecting gas at a second pressure that is set in relation to the first pressure in the outer chamber, wherein the fastening module comprises: a support protrusion installed on the outer housing; and a stopper protrusion which is installed on the outer door and is supported by the support protrusion through movement. One of the support protrusion and the stopper protrusion comprises: a protrusion body; and a friction reduction member which is attached to the protrusion body to come into contact with the other one of the support protrusion and the stopper protrusion during the movement, and has a frictional coefficient that is less than the frictional coefficient of the protrusion body and the other one of the support protrusion and the stopper protrusion.

## Description

### [Technical Field]

The present invention relates to an apparatus used for processing a substrate at a high pressure.

### [Background Art]

In general, various processing may be performed on a semiconductor wafer during a manufacturing process of a semiconductor device. Examples of the processing may include oxidation, nitriding, deposition, silicide, ion implantation, and the like. The example may also include a hydrogen or deuterium heat treatment process for improving interface characteristics of the semiconductor device.

A gas used for the processing may be supplied into a chamber to reach a high pressure and act on a semiconductor substrate. In order to maintain the high pressure inside the chamber, the fastening between the housing and door of a chamber needs to be strong. To this end, a fastening structure is adopted in which a portion of the housing and a portion of the door are interlocked with each other to allow one of the housing and the door to support the other one of the housing and the door.

In a process of reaching a state where one of the housing and the door supports the other one of the housing and the door, friction may occur due to a relative movement between the housing and the door. The friction may cause the housing and the door to wear and form particles. The wear may cause a seal between the housing and the door to deteriorate. The particles may also contaminate a workpiece to be processed.

The related art described above is technical information that the inventor possessed to derive embodiments of the present invention or acquired during its derivation process, and may not necessarily be considered to belong to the known art publicly disclosed prior to this application.

### [Disclosure]

### [Technical Problem]

An object of the present invention is to provide a high-pressure substrate processing apparatus that minimizes wear and formation of particles that may occur in a fastening structure of a chamber.

### [Technical Solution]

According to an embodiment of the present invention, provided is a high-pressure substrate processing apparatus including: an inner chamber for accommodating a substrate to be processed; an outer chamber including an outer housing for accommodating the inner chamber and an outer door movable between a closed state for closing the outer housing and an open state for opening the outer housing; and a fastening module configured to fasten the outer housing and the outer door to each other in the closed state to maintain a processing gas for processing the substrate in the inner chamber at a first pressure higher than atmospheric pressure and to maintain a protective gas in the outer chamber at a second pressure set in relation to the first pressure, wherein the fastening module includes a support protrusion associated with the outer housing, and an engaging protrusion installed on the outer door and supported on the support protrusion as the engaging protrusion transitions from a first relationship in which the engaging protrusion is offset from the support protrusion to a second relationship in which the engaging protrusion corresponds to the support protrusion, and one of the support protrusion and the engaging protrusion includes a protrusion body, and a friction reduction member mounted on the protrusion body to come into contact with the other one of the support protrusion and the engaging protrusion during the transition from the first relationship to the second relationship, and having a lower frictional coefficient than the protrusion body and the other one of the support protrusion and the engaging protrusion.

The protrusion body and the other one of the support protrusion and the engaging protrusion may be made of a first metal, and the friction reduction member may be made of one of reinforced plastic and a second metal softer than the first metal.

The protrusion body may include an accommodating part, and a peripheral part protruding beyond the accommodating part from at least one of two sides of the accommodating part, and the friction reduction member may include an insertion part inserted into the accommodating part, and a contact part supported on the peripheral part and in contact with the other one of the support protrusion and the engaging protrusion in the closed state.

The accommodating part may extend in a direction intersecting with a direction of the transition.

The accommodating part may have a width that becomes narrower as the accommodating part moves away from the protrusion body, and the insertion part may have a shape corresponding to the shape of the accommodating part.

The one of the support protrusion and the engaging protrusion may further include a fixing piece for fixing the friction reduction member to the protrusion body.

The fastening module may further include a rotating member, which forms a second plane parallel to a first plane formed by the one of the support protrusion and the engaging protrusion, and the support protrusion may protrude from the rotating member and be placed for supporting the engaging protrusion as the rotating member rotates.

The rotating member may include a rotating ring rotatably installed on the outer housing.

The support protrusion may include a friction reduction member, and the friction reduction member may be disposed on the top of the protrusion body.

The inner chamber may include an inner housing and an inner door, and the inner door may be connected to the outer door to close or open the inner housing in conjunction with a movement of the outer door.

The second pressure may be higher than the atmospheric pressure.

According to another embodiment of the present invention, provided is a high-pressure substrate processing apparatus including: a chamber including a housing and a door for opening and closing the housing; and a fastening module configured to fasten the housing and the door to each other to maintain a process gas injected into the chamber at a pressure higher than atmospheric pressure, wherein the fastening module includes a support protrusion associated with the housing, and an engaging protrusion installed on the door and supported on the support protrusion as the engaging protrusion transitions from a first relationship in which the engaging protrusion is offset from the support protrusion to a second relationship in which the engaging protrusion corresponds to the support protrusion, and one of the support protrusion and the engaging protrusion includes a protrusion body, and a friction reduction member mounted on the protrusion body to come into contact with the other one of the support protrusion and the engaging protrusion during the transition from the first relationship to the second relationship, and having a lower frictional coefficient than the protrusion body and the other one of the support protrusion and the engaging protrusion.

The fastening module may further include a rotating ring rotatably installed on the housing, and the support protrusion may protrude from the rotating ring and be placed for supporting the engaging protrusion as the rotating ring rotates.

The protrusion body and the other one of the support protrusion and the engaging protrusion may be made of a first metal, and the friction reduction member may be made of one of reinforced plastic and a second metal softer than the first metal.

The protrusion body may include an accommodating part, and a peripheral part protruding beyond the accommodating part from at least one of two sides of the accommodating part, and the friction reduction member may include an insertion part inserted into the accommodating part, and a contact part supported on the peripheral part and in contact with the other one of the support protrusion and the engaging protrusion.

### [Advantageous Effects]

According to the high-pressure substrate processing apparatus according to the present invention configured as described above, the fastening module that fastens the housing and door of the chamber to each other may have the support protrusion and the engaging protrusion supported by the support protrusion, and one of the protrusions may have the friction reduction member having the frictional coefficient lower than the other one of the protrusions, thus significantly reducing the wear and the particles occurring during the fastening process.

As the wear is reduced, the sealing performance of the chamber in the fastened state may be maintained for a long time. As the particle occurrence is reduced, the possibility of contamination of the workpiece to be processed by the particles may be significantly reduced.

### [Description of Drawings]

FIG. 1 is a conceptual diagram of a high-pressure substrate processing apparatus 100 according to an embodiment of the present invention.
FIG. 2 is a perspective view showing an open state of the high-pressure substrate processing apparatus 100 in FIG. 1 in which an outer door 125 opens an outer housing 121.
FIG. 3 is a cross-sectional view showing a relationship between a support protrusion 153 and a engaging protrusion 157 when implementing a closed state in which the outer door 125 in FIG. 2 closes the outer housing 121.
FIG. 4 is a partial perspective view showing a fastened state between the outer housing 121 and outer door 125 of the high-pressure substrate processing apparatus 100 in FIG. 2.
FIG. 5 is an enlarged cross-sectional view showing the support protrusion 153 in FIG. 2.
FIG. 6 is a cross-sectional view showing a support protrusion 153' according to a modified example of the support protrusion 153 in FIG. 5.

### [Detailed Description]

Hereinafter, a high-pressure substrate processing apparatus according to embodiments of the present invention is described in detail with reference to the accompanying drawings. Throughout this specification, components that are the same as or similar to each other are denoted by reference numerals that are the same as or similar to each other even in a different embodiment, and a description thereof is replaced by the first description.

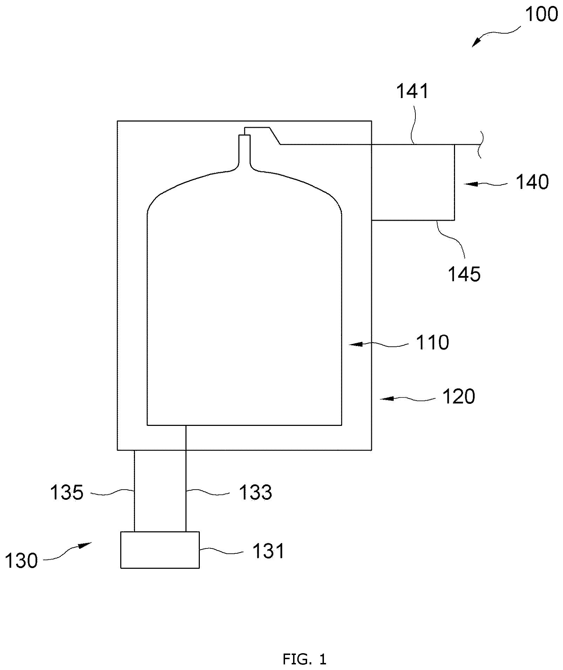

FIG. 1 is a conceptual diagram of a high-pressure substrate processing apparatus 100 according to an embodiment of the present invention.

Referring to FIG. 1, the high-pressure substrate processing apparatus 100 may include an inner chamber 110, an outer chamber 120, a gas supply module 130, and a gas exhaust module 140.

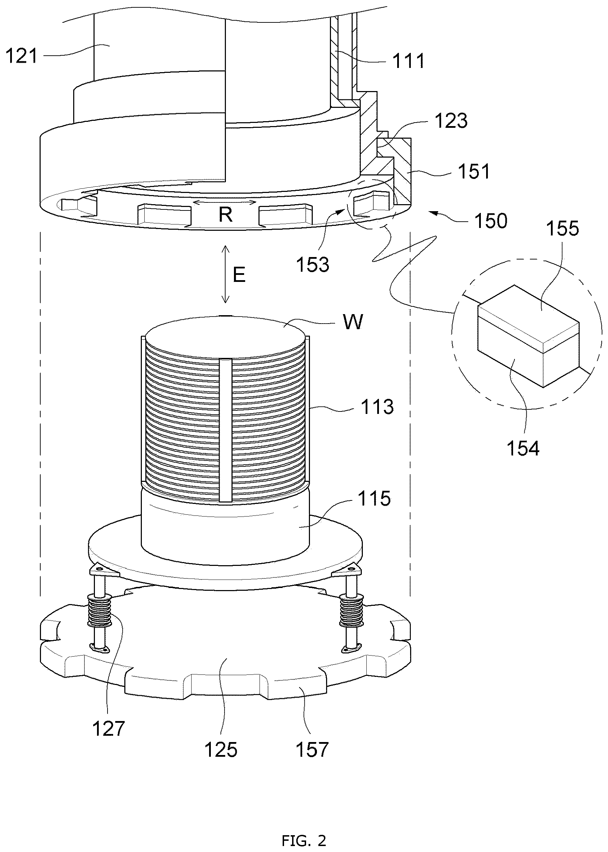

The inner chamber 110 may form an accommodating space that accommodates a substrate to be processed. The inner chamber 110 may be made of a non-metallic material, such as quartz, to reduce a risk of contamination of the substrate in a high-temperature and high-pressure working environment. A temperature in the inner chamber 110 may reach several hundred to several thousand degrees Celsius depending on an operation of a heater (not shown) disposed outside the inner chamber 110. The substrate may be, for example, a semiconductor wafer W (see FIG. 2) mounted on a holder 113 (see FIG. 2). The substrate is not limited to the aforementioned wafer, and may be any other structure as long as the substrate serves as a base structure for manufacturing a circuit. For example, the substrate may also include glass for manufacturing a display. The holder 113 may be a boat capable of stacking the substrates to be processed in a plurality of layers.

The outer chamber 120 may accommodate the inner chamber 110. Unlike the inner chamber 110, the outer chamber 120 may be made of a metal, as the outer chamber 120 is free from the risk of contamination of the substrate. The outer chamber 120 may have a hollow shape having an internal space that accommodates the inner chamber 110.

The gas supply module 130 is a component that supplies a gas to the inner chamber 110 and the outer chamber 120. The gas supply module 130 may have a gas supply device 131 that serves as a source of the gas. The gas supply device 131 may selectively supply, for example, hydrogen/deuterium gas, fluorine gas, ammonia gas, chlorine gas, or nitrogen gas, as a processing gas to the inner chamber 110. The gas supply device 131 may provide, for example, the nitrogen gas, which is an inert gas, as a protective gas to the outer chamber 120. The processing gas and the protective gas may be injected into the inner chamber 110 and the outer chamber 120 through a processing gas line 133 and a protective gas line 135, respectively. The protective gas injected into the outer chamber 120 may be specifically supplied to a space between the outer chamber 120 and the inner chamber 110. The processing gas and the protective gas may be simply referred to as a process gas.

The process gas may be supplied to reach a pressure higher than atmospheric pressure, for example, to form a high pressure ranging from several atmospheres to several tens of atmospheres. When a pressure of the processing gas is referred to as a first pressure and a pressure of the protective gas is referred to as a second pressure, the first pressure and the second pressure may be maintained in a set relationship (or within a set range). For example, the second pressure may be set to be substantially equal to or slightly higher than the first pressure. Such a pressure relationship may prevent the process gas from leaking from the inner chamber 110 and prevent the inner chamber 110 from breaking. The second pressure may be set to be slightly lower than the first pressure, which may also achieve a similar effect.

The gas exhaust module 140 is a component that exhausts the process gas. A gas exhaust pipe 141 may be connected to the top of the inner chamber 110 to exhaust the processing gas from the inner chamber 110. Similarly, a gas exhaust pipe 145 connected to the outer chamber 120 may be provided to exhaust the protective gas from the outer chamber 120. The gas exhaust pipes 141 and 145 may communicate with each other, and the processing gas may thus be diluted with the protective gas during an exhaust process, thereby lowering its concentration.

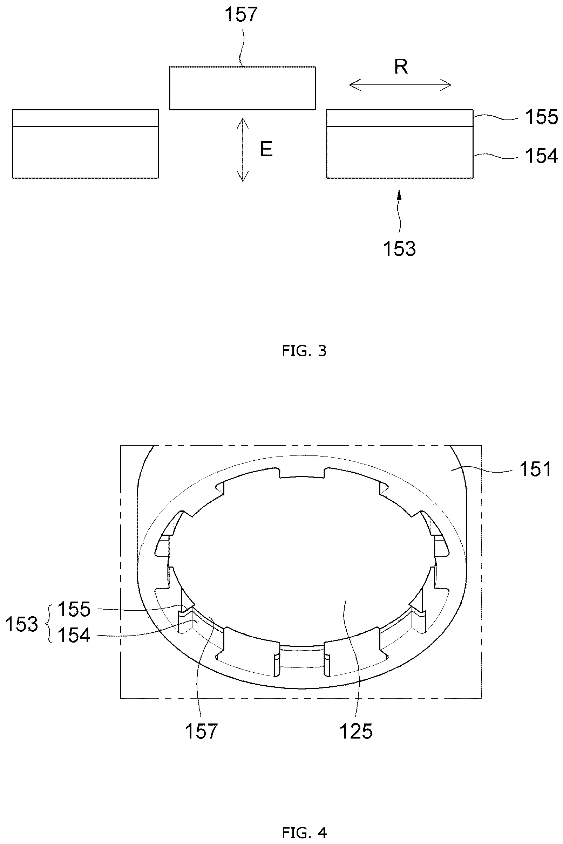

A fastening structure of the outer chamber 120 is described with reference to FIGS. 2 to 4. FIG. 2 is a perspective view showing an open state of the high-pressure substrate processing apparatus 100 in FIG. 1 in which an outer door 125 opens an outer housing 121; FIG. 3 is a cross-sectional view showing a relationship between a support protrusion 153 and an engaging protrusion 157 when implementing a closed state in which the outer door 125 in FIG. 2 closes the outer housing 121; and FIG. 4 is a partial perspective view showing a fastened state between the outer housing 121 and outer door 125 of the high-pressure substrate processing apparatus 100 in FIG. 2.

Referring to FIGS. 2 to 4, the inner chamber 110 may include an inner housing 111 and an inner door 115. The inner housing 111 may form the accommodating space that accommodates the substrate W, and its bottom may be open. The inner door 115 may close the open bottom of the inner housing 111. The inner door 115 may have an overall downward open trough shape. As the inner door 115 is lowered in an opening/closing direction E, the accommodating space may be opened (the open state, see FIG. 2). The opening/closing direction E refers to a direction in which the inner door 115 approaches or moves away from the inner housing 111. The substrate W may be loaded into or unloaded from the accommodating space in the open state. As the inner door 115 is raised in the opening/closing direction E, the inner door 115 may come into contact with the inner housing 111. In this case, the accommodating space may be referred to as being closed (the closed state).

The outer chamber 120 may also include the outer housing 121 and the outer door 125. The outer housing 121 may accommodate the entire inner chamber 110. Accordingly, the outer housing 121 may surround not only the inner housing 111 but also the inner door 115. The outer door 125 may also be moved to open and close the outer housing 121. The outer door 125 may be connected to the inner door 115 through a support member 127 and may support the inner door 115. In that case, the inner door 115 may open and close the inner housing 111 while being moved in conjunction with an elevating movement of the outer door 125. Expressions such as the 'open state' and the 'closed state' may also be applied as they are to a relationship between the outer housing 121 and the outer door 125.

The high-pressure substrate processing apparatus 100 may further include a fastening module 150 for fastening the outer housing 121 and the outer door 125 to each other in the closed state. The inner door 115 may be supported on the outer door 125 via the support member 127, and the fastening module 150 may thus also fasten the inner door 115 to the inner housing 111. The fastening module 150 may ensure that the protective gas is maintained at the second pressure in the outer chamber 120. The fastening module 150 may also exert a fastening force to ensure that the processing gas is maintained at the first pressure in the inner chamber 110.

The fastening module 150 may specifically include a rotating ring 151, the support protrusion 153, and the engaging protrusion 157.

The rotating ring 151 may be installed on the outer housing 121 and rotate around a central axis of the outer housing 121. In detail, a ring-shaped guide groove 123 may be disposed in an outer surface of the outer housing 121. The rotating ring 151 may be inserted into the guide groove 123 and rotate around a circumference of the outer housing 121. A power for rotating the rotating ring 151 may be provided from a drive wheel (not shown) in contact with the rotating ring 151. The rotating ring 151 may form a second plane parallel to a first plane formed by the support protrusion 153 or the engaging protrusion 157, which is described below. The first plane and the second plane may be substantially perpendicular to the opening/closing direction E.

The support protrusion 153 may be a protrusion installed in the outer housing 121. The support protrusion 153 may be installed in the outer housing 121 via the rotating ring 151. In detail, the support protrusion 153 may protrude from an inner circumferential surface of the rotating ring 151, and the plurality of support protrusions 153 may be arranged along a circumferential direction of the rotating ring 151.

The support protrusion 153 may include a protrusion body 154 and a friction reduction member 155. The protrusion body 154 may be formed integrally with the rotating ring 151. The friction reduction member 155 may be a separate member from the rotating ring 151 and may be mounted on the top of the protrusion body 154. If the friction reduction member 155 is in contact with the engaging protrusion 157, the protrusion body 154 may support the friction reduction member 155.

The friction reduction member 155 may have a lower frictional coefficient than the engaging protrusion 157 and the protrusion body 154. For example, if the engaging protrusion 157 or the protrusion body 154 is made of a first metal, the friction reduction member 155 may be made of a second metal that is softer than the first metal. The friction reduction member 155 may also be made of reinforced plastic.

The engaging protrusion 157 may be a protrusion installed on the outer door 125. The engaging protrusion 157 may be sized to pass through a space between adjacent pairs of support protrusions 153 when the outer door 125 is raised in the opening/closing direction E. The engaging protrusion 157 may be positioned at a higher level than the support protrusion 153 in the closed state (see FIG. 3). As the support protrusion 153 rotates in a rotational direction R, the engaging protrusion 157 may be positioned on the support protrusion 153 and supported on the support protrusion 153 (the fastened state, see FIG. 4). A level of the outer door 125 in the fastened state may be substantially the same as that in the closed state. The fastened state may also be understood as one of the closed states.

Based on this configuration, the engaging protrusion 157 may be offset from the support protrusion 153 (a first relationship, see FIG. 3), and the outer door 125 may be raised in the opening/closing direction E to be in the closed state. As the rotating ring 151 rotates in the rotational direction R in the closed state, the support protrusion 153 may rotate relative to the engaging protrusion 157. An upper surface of the support protrusion 153 may come into contact with a lower surface of the engaging protrusion 157 and rotate. Due to this rotation, the support protrusion 153 may be positioned to correspond to the engaging protrusion 157 (a second relationship, see FIG. 2).

The upper surface of the support protrusion 153 is the friction reduction member 155, and the friction reduction member 155 may thus minimize its friction with the engaging protrusion 157 by using its low frictional coefficient. As a result, wear of the support protrusion 153 and the engaging protrusion 157 and particle occurrence resulting therefrom may be suppressed during a transition process from the first relationship to the second relationship.

Hereinabove, the friction reduction member 155 is described as being a part of the support protrusion 153. However, the friction reduction member 155 may also be a part of the engaging protrusion 157. In that case, the friction reduction member 155 may occupy a lower portion of the engaging protrusion 157, and come into contact with the upper surface of the support protrusion 153 during the rotation.

Hereinabove, the support protrusion 153 is illustrated as rotating while the engaging protrusion 157 is stationary. However, in an alternative embodiment, the engaging protrusion 157 may rotate while the support protrusion 153 is stationary. In the latter case, a rotating member (not shown) may be rotatably installed on the outer door 125, and the engaging protrusion 157 may protrude from the rotating member. The rotating member may also form the second plane. The rotating member may be positioned in a space defined by the outer housing 121, and rotate around an axis passing through the center of a cylindrical surface of the outer door 125. The rotating member may have a ring-shaped rotating ring that accommodates the outer door 125.

In another alternative embodiment, the engaging protrusion 157 may be moved in a manner other than rotating relative to the support protrusion 153, and may be translated relative to the support protrusion 153, for example. In that case, the friction between the engaging protrusion 157 and the support protrusion 153 that occurs during the transition from the first relationship to the second relationship may also be alleviated by the friction reduction member 155.

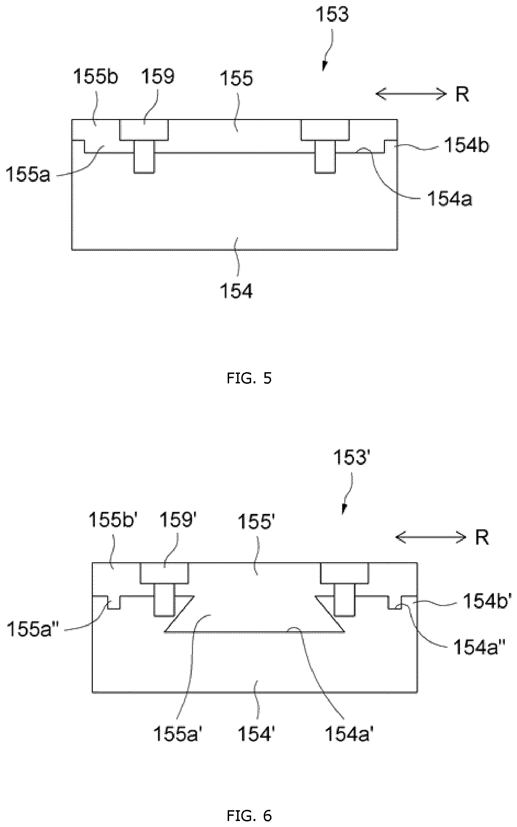

A specific form of the support protrusion 153 is described with reference to FIG. 5. FIG. 5 is an enlarged cross-sectional view showing the support protrusion 153 in FIG. 2.

Referring to FIG. 5, the protrusion body 154 may include an accommodating part 154a and a peripheral part 154b.

The accommodating part 154a may be concave compared to the peripheral part 154b. The accommodating part 154a may be positioned at the center in a width direction of the protrusion body 154. The accommodating part 154a may extend in an extension direction (a direction passing through the drawing) intersecting with the rotational direction R.

The peripheral part 154b may be positioned on a side of the accommodating part 154a. As in the present embodiment, the peripheral part 154b may be disposed on each of two sides of the accommodating part 154a. The peripheral part 154b may protrude beyond the accommodating part 154a.

The friction reduction member 155 may include an insertion part 155a and a contact part 155b.

The insertion part 155a may be a part inserted into the accommodating part 154a. The insertion part 155a may be sized to correspond to the accommodating part 154a, and thus be inserted into the accommodating part 154a without any gap. The insertion part 155a may be inserted into the accommodating part 154a by sliding along the extension direction.

The contact part 155b may be a part positioned on the top of the insertion part 155a. The contact part 155b may be supported on the peripheral part 154b. The contact part 155b may be a part that comes into contact with the engaging protrusion 157 (see FIG. 2) in the closed state.

To fix the friction reduction member 155 to the protrusion body 154, a fixing piece 159 may be further provided. The fixing piece 159 may be inserted into the friction reduction member 155 and the protrusion body 154 in a direction from the friction reduction member 155 toward the protrusion body 154. An upper surface of the fixing piece 159 may be concave and thus minimize its contact with the engaging protrusion 157.

Based on this configuration, the insertion part 155a may be inserted into the accommodating part 154a and prevented from being moved along the rotational direction R. Due to the fixing piece 159, the insertion part 155a may be prevented from being deviated from the accommodating part 154a in a height direction.

Another form of the support protrusion 153 is described with reference to FIG. 6. FIG. 6 is a cross-sectional view showing a support protrusion 153' according to a modified example of the support protrusion 153 in FIG. 5.

Referring to FIG. 6, a (first) accommodating part 154a' of a protrusion body 154' may have a width that becomes narrower as the (first) accommodating part 154a' moves away from the protrusion body 154'. A (first) insertion part 155a' may have a shape corresponding to the shape of the accommodating part 154a'.

A (second) accommodating part 154a" may be disposed on each of two sides of the accommodating part 154a'. The accommodating part 154a" may have the same shape as the previous accommodating part 154a (see FIG. 5). A (second) insertion part 155a" may also have a shape corresponding to the shape of the accommodating part 154a".

Based on this configuration, the insertion part 155a' may be inserted into the accommodating part 154a' and prevented from being moved in the rotational direction R. The insertion part 155a' may be prevented from being deviated from the accommodating part 154a' in the height direction due to not only a fixing piece 159' but also an interlocking structure between the insertion part 155a' and the accommodating part 154a'.

Due to the interlocking between the insertion part 155a" and the accommodating part 154a", both ends of a contact part 155b' may be prevented from being lifted by a shear force acting along the rotational direction R. The above shear force refers to a force that the engaging protrusion 157 exerts on the contact part 155b' along the rotational direction R during the rotation.

Although this specification describes a processing apparatus having dual chambers 110 and 120 as the high-pressure substrate processing apparatus 100 as an example, the present invention is not limited thereto. A processing apparatus having a single chamber also falls within the scope of the present invention. The single chamber may include one housing and one door. A substrate may be disposed in the chamber, and the process gas, specifically, the processing gas, for processing the substrate may be supplied thereto. The fastening module 150 may also be applied as it is to the single chamber. The fastening module 150 may ensure that the door is firmly fastened to the housing, despite the pressure of the process gas.

Although this specification exemplifies a batch-type processing apparatus, the present invention is not limited thereto. The present invention may also be applied as it is to single wafer type processing apparatus.

### [Industrial Applicability]

The present invention has industrial applicability in a field of manufacturing a high-pressure substrate processing apparatus.

## Claims

1. A high-pressure substrate processing apparatus comprising:
an inner chamber for accommodating a substrate to be processed;
an outer chamber including an outer housing for accommodating the inner chamber and an outer door movable between a closed state for closing the outer housing and an open state for opening the outer housing; and
a fastening module configured to fasten the outer housing and the outer door to each other in the closed state to maintain a processing gas for processing the substrate in the inner chamber at a first pressure higher than atmospheric pressure and to maintain a protective gas in the outer chamber at a second pressure set in relation to the first pressure,
wherein the fastening module includes
a support protrusion associated with the outer housing, and
an engaging protrusion installed on the outer door and supported on the support protrusion as the engaging protrusion transitions from a first relationship in which the engaging protrusion is offset from the support protrusion to a second relationship in which the engaging protrusion corresponds to the support protrusion, and
one of the support protrusion and the engaging protrusion includes a protrusion body, and
a friction reduction member mounted on the protrusion body to come into contact with the other one of the support protrusion and the engaging protrusion during the transition from the first relationship to the second relationship, and having a lower frictional coefficient than the protrusion body and the other one of the support protrusion and the engaging protrusion.

2. The apparatus of claim 1, wherein the protrusion body and the other one of the support protrusion and the engaging protrusion are made of a first metal, and
the friction reduction member is made of one of reinforced plastic and a second metal softer than the first metal.

3. The apparatus of claim 1, wherein the protrusion body includes
an accommodating part, and
a peripheral part protruding beyond the accommodating part from at least one of two sides of the accommodating part, and
the friction reduction member includes
an insertion part inserted into the accommodating part, and
a contact part supported on the peripheral part and in contact with the other one of the support protrusion and the engaging protrusion in the closed state.

4. The apparatus of claim 3, wherein the accommodating part extends in a direction intersecting with a direction of the transition.

5. The apparatus of claim 3, wherein the accommodating part has a width that becomes narrower as the accommodating part moves away from the protrusion body, and
the insertion part has a shape corresponding to the shape of the accommodating part.

6. The apparatus of claim 1, wherein the one of the support protrusion and the engaging protrusion further includes a fixing piece for fixing the friction reduction member to the protrusion body.

7. The apparatus of claim 1, wherein the fastening module further includes a rotating member, which forms a second plane parallel to a first plane formed by the one of the support protrusion and the engaging protrusion, and
the support protrusion protrudes from the rotating member and is placed for supporting the engaging protrusion as the rotating member rotates.

8. The apparatus of claim 7, wherein the rotating member includes a rotating ring rotatably installed on the outer housing.

9. The apparatus of claim 1, wherein the support protrusion includes a friction reduction member, and
the friction reduction member is disposed on the top of the protrusion body.

10. The apparatus of claim 1, wherein the inner chamber includes an inner housing and an inner door, and
the inner door is connected to the outer door to close or open the inner housing in conjunction with a movement of the outer door.

11. The apparatus of claim 1, wherein the second pressure is higher than the atmospheric pressure.

12. A high-pressure substrate processing apparatus comprising:
a chamber including a housing and a door for opening and closing the housing; and
a fastening module configured to fasten the housing and the door to each other to maintain a process gas injected into the chamber at a pressure higher than atmospheric pressure,
wherein the fastening module includes
a support protrusion associated with the housing, and
an engaging protrusion installed on the door and supported on the support protrusion as the engaging protrusion transitions from a first relationship in which the engaging protrusion is offset from the support protrusion to a second relationship in which the engaging protrusion corresponds to the support protrusion, and
one of the support protrusion and the engaging protrusion includes
a protrusion body, and
a friction reduction member mounted on the protrusion body to come into contact with the other one of the support protrusion and the engaging protrusion during the transition from the first relationship to the second relationship, and having a lower frictional coefficient than the protrusion body and the other one of the support protrusion and the engaging protrusion.

13. The apparatus of claim 12, wherein the fastening module further includes a rotating ring rotatably installed on the housing, and
the support protrusion protrudes from the rotating ring and is placed for supporting the engaging protrusion as the rotating ring rotates.

14. The apparatus of claim 12, wherein the protrusion body and the other one of the support protrusion and the engaging protrusion are made of a first metal, and
the friction reduction member is made of one of reinforced plastic and a second metal softer than the first metal.

15. The apparatus of claim 12, wherein the protrusion body includes
an accommodating part, and
a peripheral part protruding beyond the accommodating part from at least one of two sides of the accommodating part, and
the friction reduction member includes
an insertion part inserted into the accommodating part, and
a contact part supported on the peripheral part and in contact with the other one of the support protrusion and the engaging protrusion.
